# EUROPÄISCHE PATENTSCHRIFT

(11) **EP 3 403 064 B1**
(45) Veröffentlichungstag und Bekanntmachung des Hinweises auf die Patenterteilung: **11.08.2021**
(21) Anmeldenummer: 16810325.7
(22) Anmeldetag: 09.12.2016
(51) Int. Cl.: G01M 15/10, H05K 7/20, H05K 7/14

(54) **SCHALTSCHRANK FÜR ABGASMESSANLAGEN**
SWITCHGEAR CABINET FOR EXHAUST GAS MEASURING FACILITIES
ARMOIRE DE COMMANDE POUR SYSTÈMES DE MESURE DE GAZ D'ÉCHAPPEMENT

(30) Priorität: 15.01.2016 DE 102016100640
(43) Veröffentlichungstag der Anmeldung: 21.11.2018
(73) Patentinhaber: AVL Emission Test Systems GmbH, 41460 Neuss (DE)
(72) Erfinder: DICKOW, Achim, 42555 Velbert (DE)
(74) Vertreter: terpatent Patentanwälte ter Smitten Eberlein-Van Hoof Rütten Daubert
(86) Internationale Anmeldenummer: PCT/EP2016/080414
(87) Internationale Veröffentlichungsnummer: WO 2017/121552

(56) Entgegenhaltungen:
- DE-A1-102014 102 050
- DE-U1-202009 014 666
- US-A1- 2004 182 799
- US-A1- 2005 168 945
- US-A1- 2012 287 418
- US-A1- 2014 260 397

## Beschreibung

Die Erfindung betrifft einen Schaltschrank für Abgasmessanlagen mit einem Schrankkörper, in dem Messgeräte zur Analyse von Probengasen angeordnet sind und der zwei Seitenwände, einen Boden, eine Decke und eine Rückwand aufweist, und mit einer Tür zum Öffnen und Schließen einer offenen Frontseite des Schrankkörpers.

Derartige Schaltschränke werden beispielsweise an Rollenprüfständen von Kraftfahrzeugen verwendet, die beispielsweise eine CVS-Anlage aufweisen. Diese Schaltschränke beinhalten einerseits die Stromversorgungseinheit, Ansteuerung, Elektronik und Kühleinheiten sowie die in der Abgasmessanlage vorhandenen Regelglieder und andererseits die zur Analyse des Abgases notwendigen Messgeräte zur Bestimmung der Schadstoffmengen im Abgas, wie beispielsweise Flammenionisationsdetektoranalysegeräte zur Bestimmung von Kohlenwasserstoffen oder über einen Gaschromatographen zur Bestimmung von Methanmengen, Chemilumineszenzdetektoranalysegeräte zur Bestimmung von Stickoxidmengen im Abgas sowie Infrarotdetektoranalysegeräte zur Bestimmung verschiedener aktiver Komponenten wie Kohlenmonoxid, Kohlendioxid oder Kohlenwasserstoffverbindungen im Abgas. Entsprechend ist der Schaltschrank über Leitungen, welche über entsprechende Kupplungen an den Schaltschrank angeschlossen werden, mit den Probenahmesonden der Abgasmessanlage verbunden. Des Weiteren ist in der Regel eine für alle Messgeräte geeignete Kalibriergaseinheit im Schaltschrank angeordnet.

Diese Schränke weisen zumeist eine an der die Frontseite verschließenden Tür eine Bedieneinheit auf, über die die gesamte Anlage sowie die Messgeräte im Innenraum des Schrankes vom Bedienpersonal gesteuert wird und über die die Analysedaten unmittelbar abgefragt werden können.

Ein Schaltschrank für eine Abgasmessanlage ist beispielsweise aus der EP 2 317 833 A1 bekannt. Dieser Schaltschrank besteht aus zwei Schrankteilen, welche voreinander angeordnet werden können und die über flexible Leitungen miteinander verbunden sind. Dabei dient der hintere Schrankteil zur Verbindung mit der CVS-Anlage, während der vordere, bewegliche Schrankteil die Messgeräte der Anlage trägt, die über die Leitungen mit dem hinteren Schrankteil verbunden werden.

Des Weiteren ist aus der US 2005/0168945 A1 ein Computerreck bekannt, bei dem alle Seitenteile als Türen ausgeführt sind. Ein Luftstrom wird von der Frontseite zur Rückseite gefördert, wobei hinter jedem Computer ein Regelglied zur Regelung des Luftstroms angeordnet ist.

Zusätzlich offenbart die US 2014/0260397 A1 einen elektrischen Schrank, der allseitig geschlossen ist. Im Inneren ist eine zusätzliche Trennwand angeordnet, durch die die elektrischen Bauteile ragen und in der eine Öffnung für einen Ventilator ausgebildet ist, durch den Luft von der Frontseite zu Rückseite gefördert wird.

In der DE 20 2009 014666 U1 wird schließlich ein Schaltschrank für eine Abgasmessanlage offenbart, bei dem in einem vorderen Teil die Messgeräte angeordnet sind und in einem hinteren Teil des Schrankes die Ventile und Pumpen angeordnet sind. Die beiden Schrankteile sind zueinander verfahrbar, weisen jedoch keinen Kühlluftstrom auf.

Problematisch bei solchen Schaltschränken ist, dass einerseits Wärme erzeugt werden muss, um beispielsweise das Messgas auf vordefinierte Temperaturen zu erwärmen und andererseits auch in den Messgeräten Wärme erzeugt wird, welche zur Vermeidung von Schäden an den Messgeräten und an der im Schaltschrank vorhandenen Elektronik durch thermische Überlastung zuverlässig abgeführt werden muss.

Es stellt sich daher die Aufgabe, einen Schaltschrank für Abgasmessanlagen zur Verfügung zu stellen, mit dem Schäden an den Messgeräten und der vorhandenen Elektronik durch thermische Überlastung zuverlässig vermieden werden können und eine weitestgehend konstante Temperatur im Schaltschrank erzielbar ist. Dennoch soll der Schaltschrank möglichst in seinen Abmessungen weitestgehend unverändert bleiben und möglichst keine kostenintensiven zusätzlichen Geräte benutzt werden müssen.

Diese Aufgabe wird durch einen Schaltschrank für Abgasmessanlagen mit den Merkmalen des Hauptanspruchs 1 gelöst.

Dadurch, dass der Schrankkörper eine zweite Rückwand aufweist, wobei zwischen der ersten Rückwand und der zweiten Rückwand ein Kanal zur Wärmeabfuhr ausgebildet ist, und dass an der ersten Rückwand die Messgeräte zur Abgasanalyse anliegen, kann die im Schaltschrank entstehende Wärme abgeführt werden, da sie ungehindert aufgrund der geringeren Dichte im Kanal aufsteigt. Entsprechend wird die thermische Belastung der im Schaltschrank angeordneten Bauteile verringert. Die an den Geräten entstehende thermische Belastung kann direkt durch Konvektion über die Rückwand und den Kanal abgeführt werden.

Vorzugsweise ist im Schaltschrank mindestens ein Gebläse angeordnet, über das ein Luftstrom im Kanal erzeugbar ist. Durch dieses Gebläse wird eine stetige Luftbewegung im Kanal sichergestellt, durch die einerseits eine Kühlwirkung auf die Rückwände erzielt wird und andererseits Wärme aktiv nach oben abgeführt werden kann.

In einer bevorzugten Ausführungsform ist die zu einem Innenraum des Schrankkörpers gewandte erste Rückwand kürzer ausgeführt als die zweite Rückwand, so dass die erste Rückwand beabstandet zum Boden des Schrankkörpers angeordnet ist. Über diese Öffnung kann Luft aus dem Inneren des Schaltschrankes in den Kanal eindringen und entsprechend aus dem Schaltschrank abgeführt werden.

Es ist insbesondere vorteilhaft, wenn eine Stromversorgungseinheit in vertikaler Richtung betrachtet zwischen dem Boden des Schrankkörpers und einem unteren Ende der ersten Rückwand angeordnet ist, so dass die an der Stromversorgungseinheit entstehende Wärme direkt in den Kanal abgeführt werden kann, ohne zunächst in das Schrankinnere zu strömen.

In diesem Zusammenhang ist es besonders bevorzugt, wenn das mindestens eine Gebläse in vertikaler Richtung betrachtet zwischen dem Boden des Schrankkörpers und dem unteren Ende der ersten Rückwand angeordnet ist, wodurch die in diesem Bereich entstehende Wärme unmittelbar in den Kanal abgeführt werden kann.

Vorzugsweise ist über das Gebläse Luft aus dem Innenraum des Schrankkörpers in Richtung des Kanals zwischen der ersten Rückwand und der zweiten Rückwand förderbar. Das Gebläse saugt die warme Luft aus dem Inneren des Schrankkörpers an und fördert sie in den Kanal zwischen den Rückwänden, wo der warme Luftstrom automatisch aufgrund der Dichtedifferenz zur kälteren dort vorhandenen Luft oder erneut über ein Gebläse, abgeführt wird.

In einer vorteilhaften Ausbildung der Erfindung ist in der ersten Rückwand eine Öffnung ausgebildet, in der das mindestens eine Gebläse angeordnet ist, über welches Luft aus dem Innenraum des Schrankkörpers in den Kanal zwischen der ersten Rückwand und der zweiten Rückwand förderbar ist. Entsprechend saugt dieses Gebläse die warme Luft aus dem Innenraum des Schrankkörpers in den Kanal, aus dem die warme Luft nach oben abgeführt wird.

Vorzugsweise ist an der ersten Rückwand ein Kühler angeordnet, über den die Rückwand des Schaltschrankes oder eines der Messgeräte gekühlt wird. Bei dieser Ausführung kann die gesamte Fläche der Rückwand als Kühlfläche genutzt werden, da diese durch den Kühler heruntergekühlt wird oder die wärmere Abluft des Kühlers bei direkter Kühlung eines Messgerätes über den Kanal direkt abgeführt werden,

In einer hierzu weiterführenden Ausführungsform sind der Kühler und das Gebläse an der Öffnung in der ersten Rückwand angeordnet, so dass die warme Abluft vom Kühler entlang des Kanals gefördert wird und nicht den Innenraum erwärmt. Hierdurch sinkt die thermische Belastung des gesamten Schaltschrankinnenraums.

In einer hierzu weiterführenden Ausbildung der Erfindung weisen Seitenwände der Messgeräte unterschiedliche Seitenflächen auf, wobei die Messgeräte mit ihrer größten Seitenfläche gegen die erste Rückwand anliegen. Dies hat zur Folge, dass aufgrund der großen Auflagefläche ein besonders großer Wärmeübergang zur Rückwand besteht und damit eine maximale Wärmemenge über den Kanal abgeführt werden kann, wodurch eine thermische Überlastung der Messgeräte im Schaltschrank zuverlässig vermieden wird.

Auch ist es vorteilhaft, wenn die erste Rückwand aktiv kühlbar ist, wodurch definierte Wärmemengen in beliebiger Größe zuverlässig abgeführt werden können. Hierzu sind vorzugsweise an der ersten Rückwand Kühlschlangen angeordnet, durch die Kühlmittel förderbar ist.

Eine besonders vorteilhafte Ausführung wird geschaffen, indem die Messgeräte eine unterschiedliche Wärmemenge erzeugen, wobei die Messgeräte mit steigender erzeugter Wärmemenge weiter oben im Schrankkörper angeordnet werden. Dies erhöht die Wirkung der Kühlung über die Rückwand und den Kanal, da verhindert wird, dass eine zu große Wärmemenge aus dem unteren Bereich entlang der anderen Geräte strömt. Stattdessen bleibt immer eine Temperaturdifferenz zu der Temperatur des darüber liegenden Messgerätes vorhanden, so dass immer eine kühlende Wirkung auf das darüber liegende Messgerät entsteht, in dessen Richtung die Luft strömt.

Zusätzlich ist es vorteilhaft, wenn die erste Rückwand unterhalb der Decke endet und in der Decke zumindest ein Gebläse angeordnet ist, über das Luft aus dem Kanal und dem Innenraum des Schaltschranks förderbar ist. Die Luft aus dem Kanal wird entsprechend aktiv zur Umgebung abgeführt.

Es wird somit ein Schaltschrank für Abgasmessanlagen geschaffen, mit dem die im Schaltschrank entstehende Wärme zuverlässig abgeführt werden kann, ohne zusätzliche Abluftleitungen installieren zu müssen. Entsprechend sinkt die thermische Belastung der Messgeräte sowie der im Schaltschrank installierten Elektronik. Zusätzlich wird die Größe des Schaltschrankes reduziert. Je nach Ausführung kann so die Temperatur im Schaltschrank auf einem weitestgehend konstanten Niveau gehalten werden.

Ein Ausführungsbeispiel eines erfindungsgemäßen Schaltschranks für eine Abgasmessanlage ist in den Figuren dargestellt und wird nachfolgend beschrieben.

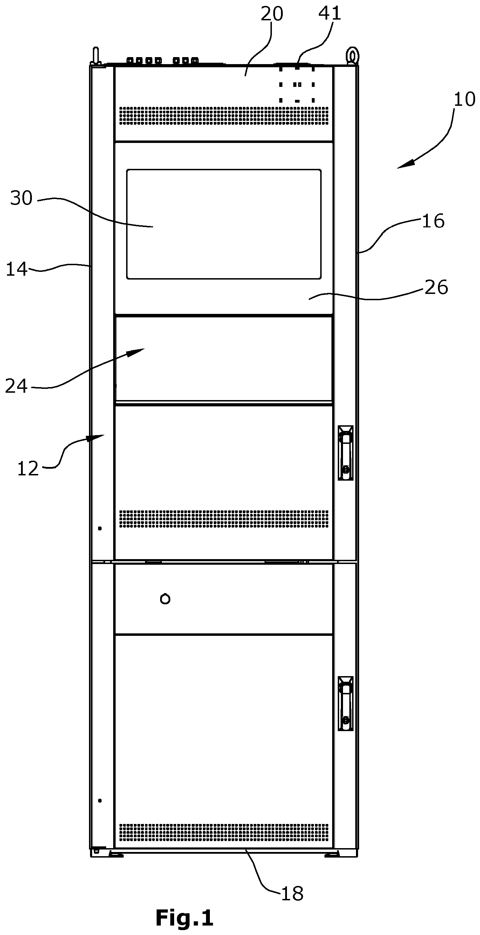

Figur 1 zeigt eine Frontansicht eines erfindungsgemäßen leeren Schaltschranks für eine Abgasmessanlage.

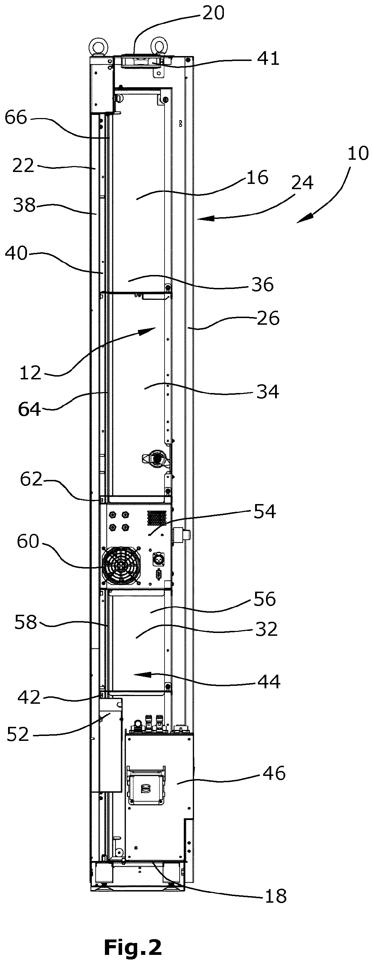

Figur 2 zeigt eine Seitenansicht des erfindungsgemäßen Schaltschranks aus Figur 1 in geschnittener Darstellung.

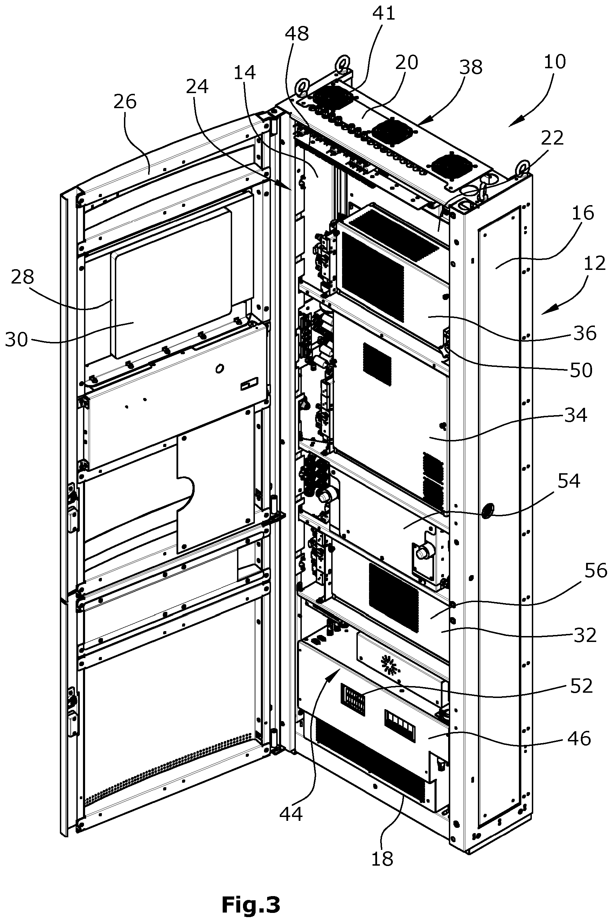

Figur 3 zeigt eine perspektivische Darstellung des vollständig ausgerüsteten geöffneten erfindungsgemäßen Schaltschranks.

Der erfindungsgemäße Schaltschrank 10 für eine Abgasmessanlage besteht aus einem ersten Schrankkörper 12 mit einer ersten Seitenwand 14, einer gegenüberliegenden Seitenwand 16, einem Boden 18 und einer Decke 20 sowie einer ersten Rückwand 22. Eine Frontseite 24 des Schrankkörpers 12 ist mittels einer Tür 26, welche schwenkbar an der ersten Seitenwand 14 befestigt ist, verschließbar. An der Tür 26 ist eine Ausnehmung 28 vorgesehen, in welcher eine Bedieneinheit 30 in Form eines Touch-Screens befestigt ist, über welche eine angeschlossene Abgasmessanlage steuerbar ist und über die die im Schaltschrank 10 angeordneten Messgeräte 32, 34, 36 zur Analyse von Probengasen ansteuerbar und deren Messergebnisse abrufbar sind.

Erfindungsgemäß weist der Schaltschrank 10 eine zweite Rückwand 38 auf, welche beabstandet zur ersten Rückwand 22 hinter der ersten Rückwand 22 und parallel zu dieser angeordnet ist. Diese zweite Rückwand 38 ist an den hinteren Enden der beiden Seitenwände 14, 16, welche nach hinten über die erste Rückwand 22 hinausragen, befestigt, so dass zwischen den beiden Rückwänden 22, 38 und den hinteren Enden der Seitenwände 14, 16 ein schmaler Kanal 40 zur Wärmeabfuhr ausgebildet wird, welcher nach oben hin offen ausgebildet ist. Auch endet die erste Rückwand 22 kurz unterhalb der Decke 20, so dass über Gebläse 41 in der Decke 20 sowohl Abluft aus dem Innenraum als auch aktiv aus dem Kanal 40 gesaugt wird.

Ein unteres Ende 42 der ersten Rückwand 22 ist ebenfalls beabstandet zum Boden 18 angeordnet. In diesem unteren Bereich des Schaltschranks 10, in dem die erste Rückwand 22 fehlt, ist in einem Innenraum 44 des Schaltschranks 10 eine Stromversorgungseinheit 46 des Schaltschranks 10 angeordnet. Eine Kalibriergaseinheit 48 sowie ein Messgasverteiler 50, über den die Messgeräte 32, 34, 36 mit dem Messgas oder dem Kalibriergas versorgt werden und der entsprechend einen Anschluss über eine Kupplung oder eine Öffnung am Schaltschrank 10 über eine nicht dargestellte Anschlussleitung zur Abgasmessanlage aufweist, sind ebenfalls im Schaltschrank 10 angeordnet.

In diesem unteren Bereich des Schaltschrankes 10 ist unmittelbar unterhalb des unteren Endes der ersten Rückwand 22 ein erstes Gebläse 52 angeordnet, welches Luft aus dem Innenraum 44 des Schaltschrankes 10 zwischen der Tür 26 und der ersten Rückwand 22 in den Kanal 40 zwischen den beiden Rückwänden 22, 38 fördert.

Im Innenraum 44 ist oberhalb der Stromversorgungseinheit 46 als erstes Messgerät 32 ein Infrarotdetektoranalysegerät zur Bestimmung verschiedener aktiver Komponenten wie Kohlenmonoxid, Kohlendioxid oder Kohlenwasserstoffverbindungen angeordnet. Dieser ist mit einem darüber angeordneten zusätzlichen Kühler 54 gekoppelt, der das Messgas des Infrarotdetektoranalysegeräts 32 kühlt und dessen warme Abluft direkt über den Kanal 40 abgeführt wird. Hierzu ist das Messgerät 32 und der Kühler 54 direkt an der Rückwand 22 befestigt. Das Infrarotdetektoranalysegerät 32 weist verschiedene Seitenwände 56 auf, von denen die Seitenwand mit der größten Seitenfläche 58 gegen die Rückwand 22 anliegt. Der Kühler 54 sowie ein weiteres Gebläse 60 sind in einer Öffnung 62 in der ersten Rückwand 22 befestigt, so dass die Luft aus dem Innenraum 44 in den Kanal 40 zwischen den Rückwänden 22, 38 gefördert wird.

Oberhalb des Infrarotdetektoranalysegerätes 32 ist als zweites Messgerät 34 ein Chemilumineszenzdetektoranalysegerät zur Bestimmung von Stickoxidmengen im Abgas an der Rückwand 22 und zwar erneut mit seiner größten Seitenfläche 64 befestigt.

Wiederum oberhalb des Chemilumineszenzdetektoranalysegerätes 34 ist als drittes Messgerät 36 ein Flammenionisationsdetektoranalysegerät zur Bestimmung von Kohlenwasserstoffen angeordnet, welches ebenfalls mit seiner größten Seitenfläche 66 gegen die gekühlte Rückwand 22 anliegt.

Im Betrieb der Abgasmessanlage entsteht im Schaltschrank Wärme. Diese wird einerseits durch die Temperatur des zu messenden Abgases erzeugt, welches gegebenenfalls auch auf definierte Temperaturen erwärmt werden muss und andererseits durch die verbaute Elektronik und die Messgeräte 32, 34, 36 selbst. Dabei entsteht die größte Wärmemenge am Flammenionisationsdetektoranalysegerät 36, die geringste Wärmemenge am Infrarotdetektoranalysegerät 32. Entsprechend ist das die größte Wärmemenge erzeugende Messgerät 36 im oberen Bereich des Schaltschrankes 10 angeordnet, während das die geringste Wärmemenge erzeugende Messgerät 32 im unteren Bereich des Schaltschrankes 10 angeordnet wird. Die im Schaltschrank 10 entstehende warme Abluft wird über die Gebläse 52, 60 aus dem Innenraum 44 des Schaltschrankes in den Kanal 40 abgeführt. Trotz dieser Abführung hat der im Kanal 40 strömende Abluftstrom eine kühlende Wirkung, da der nach oben strömende Luftstrom und damit auch die Rückwand 22 immer kälter als das jeweils in der entsprechenden Höhe an der Rückwand 22 angebrachte Messgerät 32, 34, 36, welches jeweils eine höhere Temperatur aufweist, so dass immer eine Kühlwirkung auf das jeweilige Messgerät 32, 34, 36 auf unterschiedlichen Temperaturniveaus vorliegt.

Durch diese Ausbildung der doppelten Rückwand beziehungsweise des zwischen den beiden Rückwänden 22, 38 ausgebildeten Kanals 40 wird somit einerseits stetig Wärme aus dem Innenraum 44 des Schaltschranks 10 nach oben hin abgeführt und die Messgeräte durch die geringere Temperatur der Rückwand 22 aktiv gekühlt. Somit wird eine Überlastung der Messgeräte sowie der Elektronik im Schaltschrank zuverlässig verhindert, ohne zusätzliche zu montierende Kühlkanäle oder Kühleinheiten verwenden zu müssen. Durch diese Maßnahmen wird entsprechend die thermische Belastung reduziert und gleichzeitig nur ein minimaler zusätzlicher Bauraum benötigt, so dass der Schaltschrank, auch aufgrund der Anlage der Messgeräte direkt mit ihrer größten Seitenfläche an der Rückwand mit einer sehr geringen Tiefe ausgeführt werden kann.

Es sollte deutlich sein, dass der Schutzbereich des vorliegenden Hauptanspruchs nicht auf das beschriebene Ausführungsbeispiel begrenzt ist. Insbesondere kann der Schaltschrank auch mit anderen oder zusätzlichen Messgeräten wie FTIR-Ana!ysegeräten oder Quantenkaskadenlasern oder anderen Gasanalysatoren bestückt werden. Auch die Anordnung sowie die Verbindungen der Bauteile zueinander und zur jeweiligen Abgasmessanlage sowie die Befestigung der zweiten Rückwand können geändert werden.

## Patentansprüche

1. Schaltschrank für Abgasmessanlagen mit
einem Schrankkörper (12), in dem Messgeräte (32, 34, 36) zur Analyse von Probengasen angeordnet sind und der zwei Seitenwände (14, 16), einen Boden (18), eine Decke (20) und eine Rückwand (22) aufweist,
und mit einer Tür (26) zum Öffnen und Schließen einer Frontseite (24) des Schrankkörpers (12),
**dadurch gekennzeichnet, dass**
der Schrankkörper (12) eine zweite Rückwand (38) aufweist, wobei zwischen der ersten Rückwand (22) und der zweiten Rückwand (38) ein Kanal (40) zur Wärmeabfuhr ausgebildet ist und dass an der
ersten Rückwand (22) die Messgeräte (32, 34, 36) zur Abgasanalyse anliegen.

2. Schaltschrank für Abgasmessanlagen nach Anspruch 1,
**dadurch gekennzeichnet, dass**
im Schaltschrank (10) mindestens ein Gebläse (52; 60) angeordnet ist, über das ein Luftstrom im Kanal (40) erzeugbar ist.

3. Schaltschrank für Abgasmessanlagen nach einem der Ansprüche 1 oder 2,
**dadurch gekennzeichnet, dass**
die zu einem Innenraum (44) des Schrankkörpers (12) gewandte erste Rückwand (22) kürzer ausgeführt ist als die zweite Rückwand (38), so dass die erste Rückwand (22) beabstandet zum Boden (18) des Schrankkörpers (12) angeordnet ist.

4. Schaltschrank für Abgasmessanlagen nach Anspruch 3,
**dadurch gekennzeichnet, dass**
eine Stromversorgungseinheit (46) in vertikaler Richtung betrachtet zwischen dem Boden (18) des Schrankkörpers (12) und einem unteren Ende (42) der ersten Rückwand (22) angeordnet ist.

5. Schaltschrank für Abgasmessanlagen nach einem der vorhergehenden Ansprüche,
**dadurch gekennzeichnet, dass**
das mindestens eine Gebläse (52) in vertikaler Richtung betrachtet zwischen dem Boden (18) des Schrankkörpers (12) und dem unteren Ende (42) der ersten Rückwand (22) angeordnet ist.

6. Schaltschrank für Abgasmessanlagen nach Anspruch 5,
**dadurch gekennzeichnet, dass**
über das Gebläse (52) Luft aus dem Innenraum (44) des Schrankkörpers (12) in Richtung des Kanals (40) zwischen der ersten Rückwand (22) und der zweiten Rückwand (38) förderbar ist.

7. Schaltschrank für Abgasmessanlagen nach einem der vorhergehenden Ansprüche,
**dadurch gekennzeichnet, dass**
in der ersten Rückwand (22) eine Öffnung (62) ausgebildet ist, in der das mindestens eine Gebläse (60) angeordnet ist, über weiches Luft aus dem Innenraum (44) des Schrankkörpers (12) in den Kanal (40) zwischen der ersten Rückwand (22) und der zweiten Rückwand (38) förderbar ist.

8. Schaltschrank für Abgasmessanlagen nach einem der vorhergehenden Ansprüche,
**dadurch gekennzeichnet, dass**
an der ersten Rückwand (22) ein Kühler (54) angeordnet ist.

9. Schaltschrank für Abgasmessanlagen nach Anspruch 7 und 8,
**dadurch gekennzeichnet, dass**
der Kühler (54) und das Gebläse (60) an der Öffnung (62) in der ersten Rückwand (22) angeordnet sind.

10. Schaltschrank für Abgasmessanlagen nach einem der vorhergehenden Ansprüche,
**dadurch gekennzeichnet, dass**
Seitenwände (56) der Messgeräte (32, 34, 36) eine unterschiedliche Seitenfläche aufweisen, wobei die Messgeräte mit ihrer größten Seitenfläche (58, 64, 66) gegen die erste Rückwand (22) anliegen.

11. Schaltschrank für Abgasmessanlagen nach einem der vorhergehenden Ansprüche,
**dadurch gekennzeichnet, dass**
die erste Rückwand (22) aktiv kühlbar ist.

12. Schaltschrank für Abgasmessanlagen nach Anspruch 11,
**dadurch gekennzeichnet, dass**
an der ersten Rückwand (22) Kühlschlangen angeordnet sind, durch die Kühlmittel förderbar ist.

13. Schaltschrank für Abgasmessanlagen nach einem der vorhergehenden Ansprüche,
**dadurch gekennzeichnet, dass**
die Messgeräte (32, 34, 36) eine unterschiedliche Wärmemenge erzeugen, wobei die Messgeräte (32, 34, 36) mit steigender erzeugter Wärmemenge weiter oben im Schrankkörper (12) angeordnet sind.

14. Schaltschrank für Abgasmessanlagen nach einem der vorhergehenden Ansprüche,
**dadurch gekennzeichnet, dass**
die erste Rückwand (22) unterhalb der Decke (20) endet und in der Decke (20) zumindest ein Gebläse (41) angeordnet ist.

## Claims

1. A switchgear cabinet for exhaust gas measuring facilities, comprising a cabinet body (12) in which measuring appliances (32, 34, 36) for the analysis of sample gases are arranged and which includes two side walls (14, 16), a bottom (18), a cover (20) and a rear wall (22),
and a door (26) for opening and closing a front side (24) of said cabinet body (12),
**characterized in that**
said cabinet body (12) includes a second rear wall (38), wherein between said first rear wall (22) and said second rear wall (38) a channel (40) for heat dissipation is formed,
and that the measuring appliances (32, 34, 36) for the exhaust gas analysis rest against the first rear wall (22).

2. The switchgear cabinet for exhaust gas measuring facilities according to claim 1,
**characterized in that**
in the switchgear cabinet (10) at least one fan (52; 60) is arranged via which an air flow is adapted to be generated in the channel (40).

3. The switchgear cabinet for exhaust gas measuring facilities according to any one of claims 1 or 2,
**characterized in that**
the first rear wall (22) facing an interior (44) of the cabinet body (12) is shorter than the second rear wall (38) such that said first rear wall (22) is arranged in spaced relationship to the bottom (18) of said cabinet body (12).

4. The switchgear cabinet for exhaust gas measuring facilities according to claim 3,
**characterized in that**
a power supply unit (46) is arranged between the bottom (18) of the cabinet body (12) and a lower end (42) of the first rear wall (22) as seen in the vertical direction.

5. The switchgear cabinet for exhaust gas measuring facilities according to any one of the preceding claims,
**characterized in that**
the at least one fan (52) is arranged between the bottom (18) of the cabinet body (12) and the lower end (42) of the first rear wall (22) as seen in the vertical direction.

6. The switchgear cabinet for exhaust gas measuring facilities according to claim 5,
**characterized in that**
via the fan (52) air is adapted to be delivered from the interior (44) of the cabinet body (12) towards the channel (40) between the first rear wall (22) and the second rear wall (38).

7. The switchgear cabinet for exhaust gas measuring facilities according to any one of the preceding claims,
**characterized in that**
in the first rear wall (22) an opening (62) is formed in which the at least one fan (60) is arranged via which air from the interior (44) of the cabinet body (12) is adapted to be delivered into the channel (40) between said first rear wall (22) and the second rear wall (38).

8. The switchgear cabinet for exhaust gas measuring facilities according to any one of the preceding claims,
**characterized in that**
at the first rear wall (22) a cooler (54) is arranged.

9. The switchgear cabinet for exhaust gas measuring facilities according to claim 7 and 8,
**characterized in that**
the cooler (54) and the fan (60) are arranged at the opening (62) in the first rear wall (22).

10. The switchgear cabinet for exhaust gas measuring facilities according to any one of the preceding claims,
**characterized in that**
side walls (56) of the measuring appliances (32, 34, 36) include a different side surface, wherein the largest side surface (58, 64, 66) of said measuring appliances rests against the first rear wall (22).

11. The switchgear cabinet for exhaust gas measuring facilities according to any one of the preceding claims,
**characterized in that**
the first rear wall (22) is adapted to be actively cooled.

12. The switchgear cabinet for exhaust gas measuring facilities according to claim 11,
**characterized in that**
at the first rear wall (22) cooling coils are arranged through which a coolant is adapted to be delivered.

13. The switchgear cabinet for exhaust gas measuring facilities according to any one of the preceding claims,
**characterized in that**
the measuring appliances (32, 34, 36) generate a different heat quantity, wherein, with increasing heat quantity generation, said measuring appliances (32, 34, 36) are arranged further upwards in the cabinet body (12).

14. The switchgear cabinet for exhaust gas measuring facilities according to any one of the preceding claims,
**characterized in that**
the first rear wall (22) ends beneath the cover (20) and at least one fan (41) is arranged in said cover (20).

## Revendications

1. Armoire de commande pour systèmes de mesure des gaz d'échappement comprenant
un corps d'armoire (12) dans lequel sont disposés des dispositifs de mesure (32, 34, 36) pour l'analyse de gaz de prélèvement et qui a deux parois latérales (14, 16), un fond (18), un plafond (20) et une paroi arrière (22), et avec une porte (26) pour ouvrir et fermer une face avant (24) du corps d'armoire (12),
**caractérisé en ce que**
le corps d'armoire (12) comprend une deuxième paroi arrière (38), un canal (40) de dissipation thermique étant formé entre la première paroi arrière (22) et la deuxième paroi arrière (38), et
**en ce que** les dispositifs de mesure (32, 34, 36) pour l'analyse des gaz d'échappement reposent sur la première paroi arrière (22).

2. Armoire de commande pour systèmes de mesure des gaz d'échappement selon la revendication 1, **caractérisé en ce qu'au** moins un ventilateur (52; 60) est disposé dans l'armoire de commande (10), par lequel un flux d'air peut être généré dans le canal (40).

3. Armoire de commande pour systèmes de mesure des gaz d'échappement selon l'une des revendications 1 ou 2, **caractérisé en ce que** la première paroi arrière (22) qui fait face à l'intérieur (44) du corps d'armoire (12) est plus courte que la deuxième paroi arrière (38), de sorte que la première paroi arrière (22) est espacée du fond (18) du corps d'armoire (12).

4. Armoire de commande pour systèmes de mesure des gaz d'échappement selon la revendication 3, **caractérisé en ce qu'**une unité d'alimentation (46) est disposée entre le fond (18) du corps d'armoire (12) et une extrémité inférieure (42) de la première paroi arrière (22), vu dans la direction verticale.

5. Armoire de commande pour systèmes de mesure des gaz d'échappement selon l'une quelconque des revendications précédentes, **caractérisé en ce que** ledit au moins un ventilateur (52) est disposé entre le fond (18) du corps d'armoire (12) et l'extrémité inférieure (42) de la première paroi arrière (22), vu dans la direction verticale.

6. Armoire de commande pour systèmes de mesure des gaz d'échappement selon la revendication 5, **caractérisé en ce que** l'air provenant de l'intérieur (44) du corps d'armoire (12) peut être convoyé par le ventilateur (52) en direction du canal (40) entre la première paroi arrière (22) et la deuxième paroi arrière (38).

7. Armoire de commande pour systèmes de mesure des gaz d'échappement selon l'une quelconque des revendications précédentes, **caractérisé en ce qu'**une ouverture (62) est formée dans la première paroi arrière (22), dans laquelle ouverture ledit au moins un ventilateur (60) est disposé, par lequel l'air peut être convoyé de l'intérieur (44) du corps d'armoire (12) dans le canal (40) entre la première paroi arrière (22) et la deuxième paroi arrière (38).

8. Armoire de commande pour systèmes de mesure des gaz d'échappement selon l'une quelconque des revendications précédentes, **caractérisé en ce qu'un** refroidisseur (54) est disposé sur la première paroi arrière (22).

9. Armoire de commande pour systèmes de mesure des gaz d'échappement selon les revendications 7 et 8, **caractérisé en ce que** le refroidisseur (54) et le ventilateur (60) sont disposés à l'ouverture (62) de la première paroi arrière (22).

10. Armoire de commande pour systèmes de mesure des gaz d'échappement selon l'une des revendications précédentes, **caractérisé en ce que** les parois latérales (56) des dispositifs de mesure (32, 34, 36) présentent une surface latérale différente, la plus grande surface latérale (58, 64, 66) des dispositifs de mesure reposant sur la première paroi arrière (22).

11. Armoire de commande pour systèmes de mesure des gaz d'échappement selon l'une quelconque des revendications précédentes, **caractérisé en ce que** la première paroi arrière (22) peut être refroidie activement.

12. Armoire de commande pour systèmes de mesure des gaz d'échappement selon la revendication 11, **caractérisé en ce que** des serpentins de refroidissement sont disposés sur la première paroi arrière (22), à travers lesquels serpentins le fluide de refroidissement peut être convoyé.

13. Armoire de commande pour systèmes de mesure des gaz d'échappement selon l'une quelconque des revendications précédentes, **caractérisé en ce que** les dispositifs de mesure (32, 34, 36) génèrent une quantité de chaleur différente, les dispositifs de mesure (32, 34, 36) étant disposés plus haut dans le corps d'armoire (12) avec l'augmentation de la quantité de chaleur générée.

14. Armoire de commande pour systèmes de mesure des gaz d'échappement selon l'une quelconque des revendications précédentes, **caractérisé en ce que** la première paroi arrière (22) se termine sous le plafond (20) et qu'au moins un ventilateur (41) est disposé dans le plafond (20).
